# EUROPÄISCHE PATENTSCHRIFT

(11) **EP 1 540 712 B1**
(45) Veröffentlichungstag und Bekanntmachung des Hinweises auf die Patenterteilung: **09.12.2009**
(21) Anmeldenummer: 03794962.5
(22) Anmeldetag: 28.08.2003
(51) Int. Cl.: H01L 21/027, H01L 21/033, H01L 21/308, H01L 21/311, H01L 21/768

(54) **HERSTELLUNGSVERFAHREN FÜR EINE HALBLEITERSTRUKTUR**
METHOD FOR PRODUCTION OF A SEMICONDUCTOR STRUCTURE
PROCEDE DE FABRICATION D'UNE STRUCTURE A SEMICONDUCTEUR

(30) Priorität: 30.08.2002 DE 10240099
(43) Veröffentlichungstag der Anmeldung: 15.06.2005
(73) Patentinhaber: Infineon Technologies AG, 81669 München (DE)
(72) Erfinder: GENZ, Oliver, 01324 Dresden (DE); KIRCHHOFF, Markus, 01458 Ottendorf-Okrilla (DE); MACHILL, Stefan, 01217 Dresden (DE); REB, Alexander, 01109 Dresden (DE); SCHMIDT, Barbara, 01326 Dresden (DE); STAVREV, Momtchil, 01109 Dresden (DE); STEGEMANN, Maik, 01157 Dresden (DE); WEGE, Stephan, 01328 Dresden (DE)
(74) Vertreter: Barth, Stephan Manuel
(86) Internationale Anmeldenummer: PCT/EP2003/009551
(87) Internationale Veröffentlichungsnummer: WO 2004/025714

(56) Entgegenhaltungen:
- EP-A- 1 184 903
- WO-A-00/03432
- DE-A- 4 201 661
- US-B1- 6 225 217
- US-B1- 6 340 435

## Beschreibung

Die vorliegende Erfindung betrifft ein Herstellungsverfahren für eine Halbleiterstruktur.

Obwohl prinzipiell auf beliebige integrierte Schaltungen anwendbar, werden die vorliegende Erfindung sowie die ihr zugrundeliegende Problematik in bezug auf Halbleiterstrukturen in Silizium-Technologie erläutert.

Die Strukturierung von Halbleiterstrukturen in Silizium-Technologie erfolgt durch wechselseitiges Erstellen von Masken, z.B. durch Belichten und Entwickeln von Photolackschichten, und trockenchemisches bzw. nasschemisches isotropes oder anisotropes Ätzen. Dabei ist jeder Lithographieschritt bzw. jede Lithographieebene kostspielig und aufwendig. Ziel jeder Halbleiterfertigung ist es daher, die Zahl der Lithographieschritte bzw. Lithographieebenen so klein wie möglich zu halten. Außer Kosten und Strukturgröße ist bei der lithographischen Strukturierung auch die Genauigkeit der vertikalen Justage zweier oder mehrerer übereinander liegender Lithographieebenen limitierend.

Üblicherweise wird bislang bei jeder Ebene, die lithographisch strukturiert werden soll, eine neue Photolackschicht aufgebracht, die nach erfolgter Justage über eine Maske belichtet und anschließend entwickelt wird. Nach dem Herauslösen der belichteten bzw. unbelichteten Photolackbereiche im Entwicklungsprozess erfolgt dann eine Strukturierung der unter der Photolackmaske liegenden Halbleiterschicht mittels eines geeigneten Ätzprozesses, beispielsweise mittels reaktivem Ionen-Ätzens.

Die der vorliegenden Erfindung zugrundeliegende Problematik besteht darin, ein verbessertes Herstellungsverfahren für eine Halbleiterstruktur zu schaffen, das es ermöglich, weniger Lithographieschritte bzw. Lithographieebenen vorzusehen.

Erfindungsgemäß wird dieses Problem durch das in Anspruch 1 angegebene Herstellungsverfahren gelöst.

Die Vorteile des erfindungsgemäßen Herstellungsverfahrens liegen insbesondere darin, dass zur Übertragung zweier verschiedener Grabenstrukturen in ein Halbleitersubstrat nur eine einzige Lithographieebene zur Strukturierung der oberen dritten Maskenschicht notwendig ist.

Die der vorliegenden Erfindung zugrundeliegende Idee besteht darin, das Fenster in der oberen dritten Maskenschicht in die darunterliegenden Maskenschichten zu übertragen und an bestimmter Stelle in einem maskenlosen Prozessschritt selbstjustierend zu verbreitern und das verbreiterte Fenster ebenfalls in die darunterliegenden Maskenschichten zu übertragen und das Substrat nacheinander mit dem Fenster und dem verbreiterten Fenster zu strukturieren.

In den Unteransprüchen finden sich vorteilhafte Weiterbildungen und Verbesserungen des Gegenstandes der Erfindung.

Gemäss einer bevorzugten Weiterbildung erfolgen das Strukturieren der unteren ersten Maskenschicht unter Verwendung des ersten Fensters in der mittleren zweiten Maskenschicht zum Übertragen des ersten Fensters in die untere erste Maskenschicht und das Vergrößern des ersten Fensters in der oberen dritten Maskenschicht simultan in einem einzigen Ätzschritt, der selektiv zum Halbleitersubstrat und zur mittleren zweiten Maskenschicht ist.

Gemäss einer weiteren bevorzugten Weiterbildung erfolgen das Strukturieren des Halbleitersubstrats unter Verwendung der strukturierten unteren dritten Maskenschicht und das Umstrukturieren der mittleren zweiten Maskenschicht unter Verwendung des zweiten Fensters in der oberen dritten Maskenschicht zum Übertragen des zweiten Fensters in die mittlere zweite Maskenschicht simultan in einem einzigen Ätzschritt, der selektiv zur unteren ersten Maskenschicht und zur mittleren zweiten Maskenschicht ist.

Gemäss einer weiteren bevorzugten Weiterbildung wird beim Strukturieren des Halbleitersubstrats ein erster Graben geschaffen und beim Umstrukturieren des Halbleitersubstrats ein zweiter breiterer, weniger tiefer Graben geschaffen.

Gemäss einer weiteren bevorzugten Weiterbildung besteht das Halbleitersubstrat aus Siliziumoxid, die untere erste Maskenschicht aus Kohlenstoff, die mittlere zweite Maskenschicht aus Siliziumoxinitrid und die obere dritte Maskenschicht aus Photolack.

Gemäß einer weiteren bevorzugten Weiterbildung besteht das Halbleitersubstrat aus Siliziumoxid, die untere erste Maskenschicht aus Polysilizium, die mittlere zweite Maskenschicht aus Siliziumoxid und die obere dritte Maskenschicht aus Photolack.

Gemäß einer weiteren bevorzugten Weiterbildung besteht das Halbleitersubstrat aus Siliziumoxid, die untere erste Maskenschicht aus Polysilizium, die mittlere zweite Maskenschicht aus Siliziumnitrid und die obere dritte Maskenschicht aus Photolack.

Gemäß einer weiteren bevorzugten Weiterbildung besteht das Halbleitersubstrat aus Siliziumoxid, die untere erste Maskenschicht aus Siliziumnitrid, die mittlere zweite Maskenschicht aus Polysilizium und die obere dritte Maskenschicht aus Photolack.

Gemäß einer weiteren bevorzugten Weiterbildung besteht das Halbleitersubstrat aus Silizium, die untere erste Maskenschicht aus Siliziumnitrid, die mittlere zweite Maskenschicht aus Siliziumoxid und die obere dritte Maskenschicht aus Photolack.

Gemäß einer weiteren bevorzugten Weiterbildung wird eine Mehrzahl von ersten Fenstern in der oberen dritten Maskenschicht gebildet wird.

Gemäß einer weiteren bevorzugten Weiterbildung wird die Mehrzahl von ersten Fenstern zu einer entsprechenden Mehrzahl von zweiten Fenstern in dem maskenlosen Prozessschritt vergrößert.

Gemäß einer weiteren bevorzugten Weiterbildung wird die Mehrzahl von ersten Fenstern zu einer verringerten Anzahl von zweiten Fenstern in dem maskenlosen Prozessschritt vergrößert, indem mindestens einige der ersten Fenster beim Vergrößern miteinander verbunden werden.

Gemäß einer weiteren bevorzugten Weiterbildung sind die ersten Fenster in einer oder mehreren Reihen angeordnet, wobei die jeweils in einer gemeinsamen Reihe liegenden Fenster zu einem jeweiligen Streifen miteinander verbunden werden.

Gemäß einer weiteren bevorzugten Weiterbildung ist das Halbleitersubstrat ein Zwischenmetalldielektrikum.

Ausführungsbeispiele der Erfindung sind in den Zeichnungen dargestellt und in der nachfolgenden Beschreibung näher erläutert.
- Fig. 1a-f: zeigen schematische Darstellungen aufeinanderfol- gender Verfahrensstadien eines Herstellungsverfah- rens für eine Halbleiterstruktur als erste Ausfüh- rungsform der vorliegenden Erfindung; und
- Fig. 2a-f: zeigen schematische Darstellungen aufeinanderfol- gender Verfahrensstadien eines Herstellungsverfah- rens für eine Halbleiterstruktur als zweite Ausfüh- rungsform der vorliegenden Erfindung.

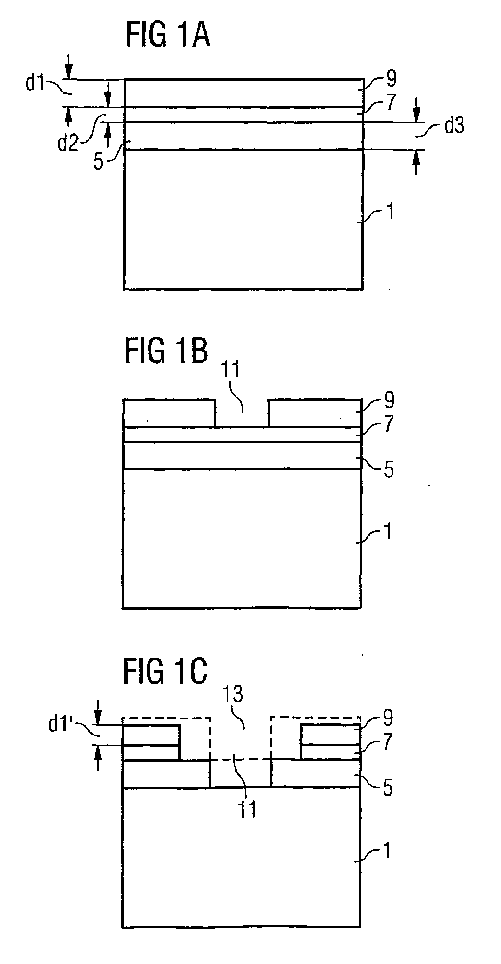

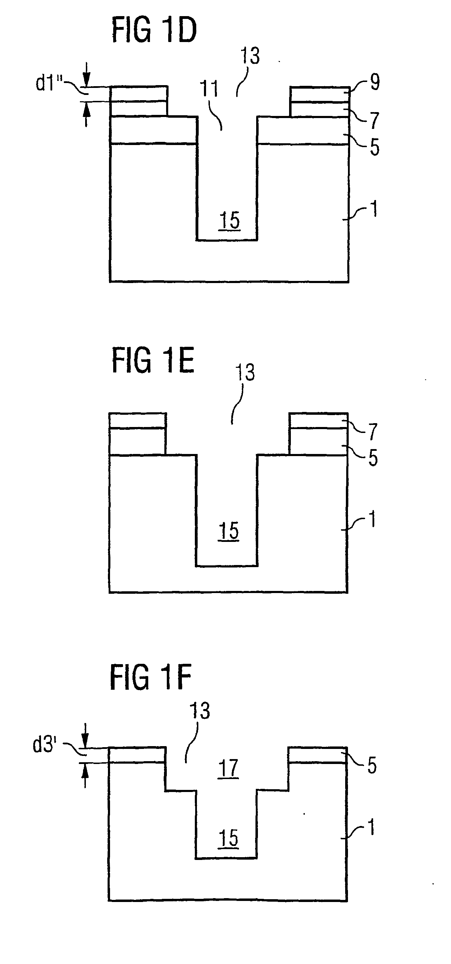

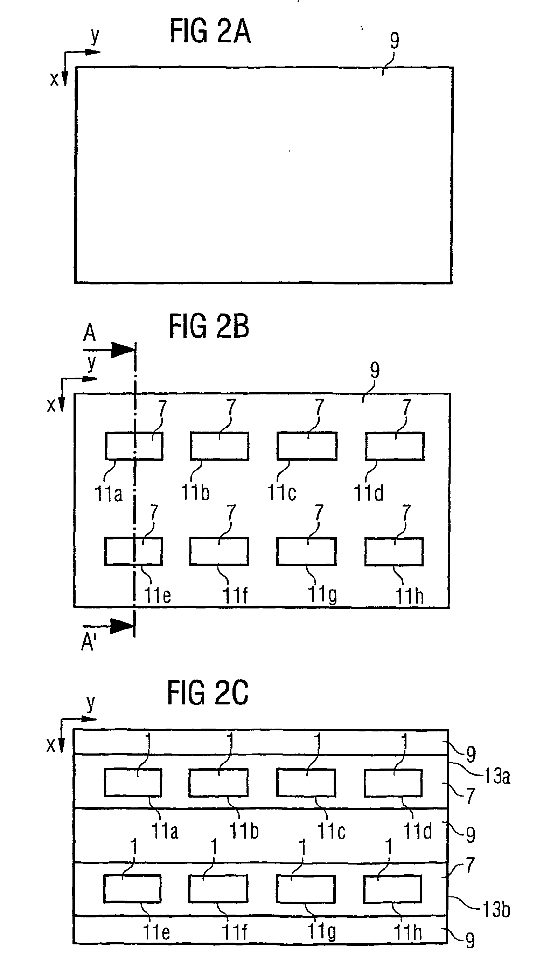

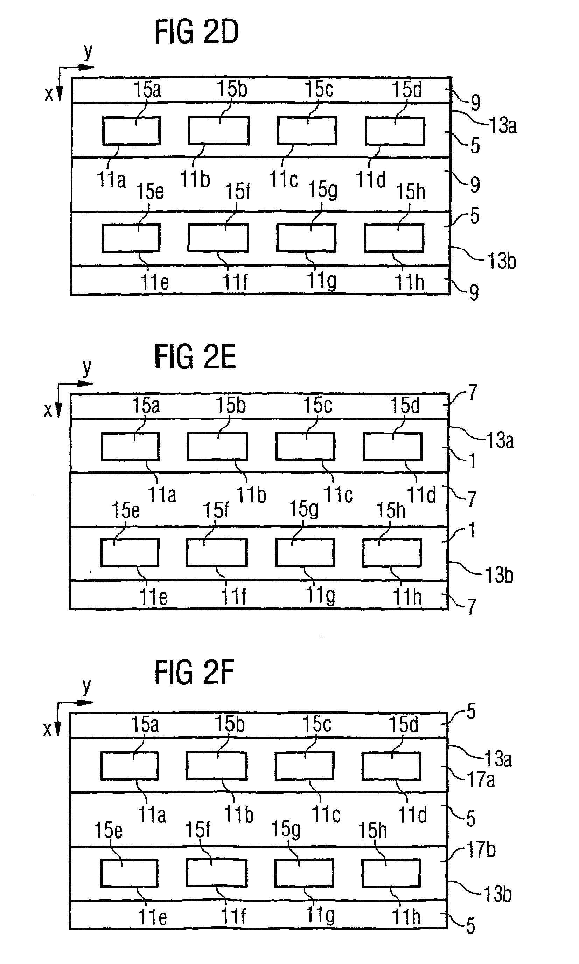

In Fig. 1 und 2 bezeichnen gleiche Bezugszeichen gleiche oder funktionsgleiche Bestandteile.

Fig. 1a-f zeigen schematische Darstellungen aufeinanderfolgender Verfahrensstadien eines Herstellungsverfahrens für eine Halbleiterstruktur als erste Ausführungsform der vorliegenden Erfindung.

In Fig. 1a bezeichnet Bezugszeichen 1 ein Halbleitersubstrat aus Siliziumoxid (sich). Dieses Halbleitersubstrat 1 ist hier aus Gründen der Vereinfachung ohne einen darunterliegenden Silizium-Wafer bzw. andere darunterliegende Schichten gezeichnet, auf dem bzw. denen das Siliziumoxid-Halbleitersubstrat 1 durch einen Oxidationsprozess, einen Abscheidungsprozess, einen Epitaxieprozess, einen Direct-Bonding-Prozess o.ä. aufgebracht worden ist.

In einem ersten Verfahrensschritt werden auf dem Halbleitersubstrat 1 eine untere erste Maskenschicht 5 aus Kohlenstoff mit einer Dicke d3, eine mittlere zweite Maskenschicht 7 aus Siliziumoxinitrid mit einer Dicke d2 und eine obere dritte Maskenschicht 9 aus Photolack mit einer Dicke d1 vorgesehen. Üblicherweise werden die Maskenschichten 5 und 7 abgeschieden und die Maskenschicht 9 aufgeschleudert.

Mit Bezug auf Fig. 1b wird dann in einem üblichen Lithographieschritt unter Verwendung einer nicht gezeigten Belichtungsmaske ein erstes Fenster 11 in der oberen dritten Maskenschicht 9 aus Photolack gebildet. Dies wird dadurch erleichtert, dass die mittlere zweite Maskenschicht 7 aus Siliziumoxinitrid Antireflexions-Eigenschaften (ARC) aufweist.

Im darauffolgenden Verfahrensschritt, welcher in Fig. 1c illustriert ist, erfolgt dann zunächst eine erste Ätzung der mittleren zweiten Maskenschicht 7 aus Siliziumoxinitrid selektiv zur Maskenschicht 9 aus Photolack, um das erste Fenster 11 in der oberen dritten Maskenschicht 9 aus Photolack in die mittlere zweite Maskenschicht 7 aus Siliziumoxinitrid zu übertragen. Dies führt zunächst zum Prozesszustand, welcher durch die gestrichelte Linie in Fig. 1c umrandet ist. Diese erste Ätzung erfolgt im übrigen zweckmäßigerweise mittels reaktiven Ionen-Ätzens.

In einem darauffolgenden Schritt erfolgt dann eine zweite Ätzung zum Ätzen der unteren ersten Maskenschicht 5 aus Kohlenstoff selektiv zur mittleren zweiten Maskenschicht 7 aus Siliziumoxinitrid zum Weiterübertragen des ersten Fensters 11 in die untere erste Maskenschicht 5.

Eine Besonderheit bei dieser ersten Ausführungsform liegt darin, dass diese zweite Ätzung zwar selektiv zur mittleren zweiten Maskenschicht 7 aus Siliziumoxinitrid ist, jedoch nicht selektiv zur oberen dritten Maskenschicht 9 aus Photolack. Dies führt dazu, dass einerseits das erste Fenster 11 in die untere erste Maskenschicht 5 aus Kohlenstoff übertragen wird, wobei die zweite Ätzung derart gewählt ist, dass sie auf dem Halbleitersubstrat 1 aus SiO₂ stoppt, andererseits durch die zweite Ätzung aber gleichzeitig auch die obere dritte Maskenschicht 9 aus Photolack getrimmt wird. Trimmen heißt in diesem Zusammenhang, dass sich die Dicke d1 auf eine Dicke d1' verringert und zugleich das erste Fenster 11 in der oberen dritten Maskenschicht 9 auf ein zweites Fenster 13 mit einer größeren Breite verbreitert.

Mit anderen Worten erfolgt gleichzeitig zum Ätzen der ersten unteren Maskenschicht 5 eine Veränderung der Strukturierung der oberen dritten Maskenschicht 9 in situ und selbstjustierend. Diese zweite Ätzung der ersten unteren Maskenschicht 5 aus Kohlenstoff erfolgt bei den gewählten Maskenschichtmaterialien zweckmäßigerweise mit einer sauerstoffhaltigen Gasmischung im Plasma.

Nach dem Stoppen dieser zweiten Ätzung auf dem Halbleitersubstrat 1 aus SiO₂ kann man in einem bestimmten Rahmen weiter überätzen, ohne dabei die kritische Dimension, also die Breite vom ersten Fenster 11 in der unteren ersten Maskenschicht 5 aus Kohlenstoff zu verändern. Die Vergrößerung des ersten Fensters 11 in der oberen dritten Maskenschicht 9 aus Photolack lässt sich dabei als Funktion dieser Überätzzeit in dem besagten Rahmen einstellen.

In diesem Zusammenhang sei erwähnt, dass es jedoch alternativ auch möglich ist, die obere dritte Maskenschicht 9 in einem separaten maskenlosen Ätzschritt zu ätzen, wenn diese aus einem Material besteht, das sich selektiv gegen alle darunterliegenden Materialien ätzen lässt.

Weiter mit Bezug auf Fig. 1d wird dann in einem anschließenden Ätzschritt ein Graben 15 in dem Halbleitersubstrat 1 aus SiO₂ unter Verwendung des ersten Fensters 11 in der unteren ersten Maskenschicht 5 aus Kohlenstoff geätzt. Zweckmäßigerweise wird bei diesem Ätzschritt gleichzeitig die mittlere zweite Maskenschicht 7 aus Siliziumoxinitrid von dem nicht mehr mit Photolack bedeckten Bereich entfernt. Mit anderen Worten wird also simultan zur Ätzung des Halbleitersubstrats 1 aus SiO₂ das zweite Fenster 13 von der oberen dritten Maskenschicht 9 aus Photolack in die mittlere zweite Maskenschicht 7 aus Siliziumoxinitrid übertragen. Bei diesem Ätzschritt, der in Fig. 1d erläutert ist, nimmt die Dicke der oberen dritten Maskenschicht 9 weiter auf eine Dicke d1 " ab.

Auch in diesem Zusammenhang sei erwähnt, dass bei entsprechender Selektivität der Ätzungen das Vorsehen des Grabens 15 in dem Halbleitersubstrat 1 und das Übertragen des Fensters 13 in die mittlere zweite Maskenschicht 7 auch prinzipiell in zwei getrennten Ätzschritten erfolgen könnte.

Weiter mit Bezug auf Fig. 1e erfolgt dann wiederum eine Ätzung der unteren ersten Maskenschicht 5 aus Kohlenstoff zum Übertragen des zweiten Fensters 13. Diese Ätzung ist, wie zuvor mit Bezug auf Fig. 1c erwähnt, selektiv zur mittleren zweiten Maskenschicht 7 aus Siliziumoxinitrid und unselektiv zur oberen dritten Maskenschicht 9 aus Photolack. Daher wird die obere dritte Maskenschicht 9 aus Photolack bei diesem Ätzschritt vollständig entfernt. Die Ätzung stoppt aufgrund dieser Selektivität an der Oberfläche des Halbleitersubstrats 1 aus Siliziumdioxid bzw. an der Oberfläche der mittleren zweiten Maskenschicht 7.

Durch eine anschließende Ätzung des Halbleitersubstrats 1 aus Siliziumdioxid unter Verwendung des Fensters 13 in der unteren ersten Maskenschicht 5 aus Kohlenstoff lässt sich somit eine zweite Struktur in Form eines breiteren, weniger tiefen Grabens 17 in das Halbleitersubstrat 1 übertragen.

Nach alledem war zur Übertragung zweier verschiedener Grabenstrukturen 15, 17 in das Halbleitersubstrat 1 nur eine einzige Lithographieebene zur Strukturierung der oberen dritten Maskenschicht 9 aus Photolack notwendig.

Fig. 2a-f zeigen schematische Darstellungen aufeinanderfolgender Verfahrensstadien eines Herstellungsverfahrens für eine Halbleiterstruktur als zweite Ausführungsform der vorliegenden Erfindung.

Die zweite Ausführungsform gemäss Fig. 2a bis 2f verdeutlicht, dass durch die Erfindung in der Ebene der Maskenschichten sehr interessante miteinander verbundene Strukturen entstehen können. Fig. 2a bis 2f illustrieren dies in Draufsicht auf die Oberseite des Halbleitersubstrats 1, auf der sich die drei Maskenschichten 5, 7, 9 befinden. Dabei korrespondieren die Fig. 2a bis 2f paarweise zu den Fig. 1a bis 1f. Wie in Fig. 2a gezeigt, ist im Anfangsstadium die gesamte Oberfläche mit der obersten dritten Maskenschicht 9 aus Photolack bedeckt.

Mit Bezug auf Fig. 2b wird dann in dem üblichen Lithographieschritt unter Verwendung der nicht gezeigten Belichtungsmaske eine Mehrzahl erster Fenster 11a bis 11h in der oberen dritten Maskenschicht 9 aus Photolack gebildet. Um den paarweisen Zusammenhang zwischen Fig. 1a bis 1f und Fig. 2a bis 2f herzustellen, kann man sich vorstellen, dass Fig. 1a bis 1f einen Querschnitt entlang der Line A-A' in Fig. 2b darstellen.

Die Mehrzahl von ersten Fenstern 11a bis 11h hat rechteckige Dimensionen und weist in der x-Richtung größere Abstände als in der y-Richtung auf.

In einem darauffolgenden Verfahrensschritt, welcher in Fig. 2c illustriert ist, erfolgen dann die beiden Ätzungen, welche mit Bezug auf Fig. 1c ausführlich erläutert wurden.

Eine Besonderheit bei der Anordnung der ersten Fenster 11a bis 11h bei der zweiten Ausführungsform liegt darin, dass die Abstände der ersten Fenster 11a bis 11h in y-Richtung bzw. die Überätzdauer derart gewählt sind, dass die daraus entstehenden zweiten Fenster jeweils ineinander übergehen und somit Streifen 13a, 13b bilden, wie das in Fig. 2c dargestellt ist.

Allgemein gesagt kann man sich bei der Anordnung der ersten Fenster zwei Situationen vorstellen. Sind die ersten Fenster weit voneinander entfernt bzw. ist die Überätzdauer kurz genug, so entstehen in der xy-Ebene skalierte Fensterformen in Strukturen unterschiedlicher Größe. Sind die einzelnen ersten Fenster jedoch unterhalb eines bestimmten Abstandes voneinander entfernt bzw. ist die Ätzdauer lang genug, so wachsen sie in der xy-Ebene zusammen.

Auf diese Art und Weise lassen sich sogenannte Dual-Damascene-Strukturen mit einem einzigen Lithographieschritt und perfekter Justage herstellen.

Gemäss Fig. 2d wird dann in einem anschließenden Ätzschritt analog zu Fig. 1b eine Mehrzahl von einzelnen Gräben 15a bis 15h in dem Halbleitersubstrat 1 aus SiO₂ unter Verwendung der unteren ersten Maskenschicht 5 aus Kohlenstoff geätzt. Dabei wird ebenfalls die mittlere zweite Maskenschicht 7 aus Siliziumoxinitrid von dem nicht mehr mit Photolack bedeckten Bereich entfernt.

Mit Bezug auf Fig. 2e erfolgt dann die Ätzung der unteren ersten Maskenschicht 5 aus Kohlenstoff zum Übertragen der beiden zweiten streifenförmigen Fenster 13a, 13b in die untere erste Maskenschicht 5. Durch die anschließende Ätzung des Halbleitersubstrats 1 aus Siliziumdioxid unter Verwendung der streifenförmigen Fenster 13a, 13b in der untersten ersten Maskenschicht 5 aus Kohlenstoff lässt sich somit eine Struktur von zwei grabenförmigen Streifen 17a, 17b in dem Halbleitersubstrat 1 bilden, welche die Gräben 15a bis 15h miteinander verbindet, wobei die grabenförmigen Streifen 17a, 17b eine geringere Tiefe als die Gräben 15a-h aufweisen.

Eine derartige Anordnung wäre z.B. außerordentlich zweckmäßig für die Bildung von Durchkontaktierungen und Verbindungsleiterbahnen in einem Zwischenmetalldielektrikum in Form von Siliziumoxid oder einem anderen Dielektrikum bei Verwendung als Zwischenmetalldielektrikum. In diesem Fall könnte zur Erstellung der Durchkontaktierungen und Verbindungsleiterbahnen über dem von den Maskenschichten befreiten Halbleitersubstrat 1 ganzflächig eine Metallschicht, z.B. Wolfram, abgeschieden werden und bis zur Oberfläche des Halbleitersubstrats zurückpoliert werden.

Obwohl die vorliegende Erfindung vorstehend anhand eines bevorzugten Ausführungsbeispiels beschrieben wurde, ist sie darauf nicht beschränkt, sondern auf vielfältige Art und Weise modifizierbar.

Insbesondere sind die Auswahl der Masken- und Substratmaterialien deren Anordnung nur beispielhaft und können in vielerlei Art variiert werden.

Obwohl bei der obigen ersten Ausführungsform das Maskenschichtsystem aus einer unteren ersten Maskenschicht aus Kohlenstoff, einer mittleren zweiten Maskenschicht aus Siliziumoxinitrid und einer dritten oberen Maskenschicht aus Photolack bestand, ist dies nicht zwingend notwendig.

Allgemein benötigt man eine erste und eine zweite Hartmaskenschicht, die sich gegeneinander, gegen das Halbleitersubstrat und gegen die obere dritte Maskenschicht aus Photolack selektiv ätzen lassen. Dies ist üblicherweise stets realisierbar, da Photolack im Gegensatz zu Silizium, Siliziumoxid, Siliziumnitrid allein mit Sauerstoffplasma ätzbar ist. Weitere Beispiele für Maskenschichtsysteme wären also Photolack/Siliziumoxid/Polysilizium/Siliziumoxid; Photolack/Siliziumnitrid/Polysilizium/Siliziumoxid; Photolack/Polysilizium/Siliziumnitrid/Siliziumoxid für Siliziumoxid als Substrat und Photolack/Siliziumoxid/Siliziumnitrid/Silizium für Polysilizium oder monokristallines Silizium als Substrat.

Insbesondere sei noch erwähnt, dass die Anwendung des erfindungsgemäßen Verfahrens nicht auf Zwischenmetall-Dielektrika beschränkt ist, sondern an beliebiger Stelle bei der Strukturierung von Halbleiterstrukturen eingesetzt werden kann.

### Bezugszeichenliste

- 1: Siliziumdioxid-Halbleitersubstrat
- 5: erste Hartmaskenschicht aus Kohlen- stoff
- 7: zweite Hartmaskenschicht aus SiON
- 9: Lackmaskenschicht
- 11,11a-h: erste Fenster
- 13,13a-b: zweites Fenster
- 15,15a-h: erste Gräben
- 17,17a-b: zweite Gräben
- x, y: Richtungen

## Patentansprüche

1. Herstellungsverfahren für eine Halbleiterstruktur mit den Schritten:
Bereitstellen eines Halbleitersubstrats (1);
Vorsehen einer unteren ersten, einer mittleren zweiten und einer oberen dritten Maskenschicht (5, 7, 9) auf einer Oberfläche des Halbleitersubstrats (1);
Bilden mindestens eines ersten Fensters (11, 11a-h) in der oberen dritten Maskenschicht (9);
Strukturieren der mittleren zweiten Maskenschicht (7) unter Verwendung des ersten Fensters (11, 11a-h) in der oberen dritten Maskenschicht (9) zum Übertragen des ersten Fensters (11, 11a-h) in die mittlere zweite Maskenschicht (7);
Strukturieren der unteren ersten Maskenschicht (5) unter Verwendung des ersten Fensters (11, 11a-h) in der mittleren zweiten Maskenschicht (7) zum Übertragen des ersten Fensters (11, 11a-h) in die untere erste Maskenschicht (5);
Vergrößern des ersten Fensters (11, 11a-h) in der oberen dritten Maskenschicht (9) zum Bilden eines zweiten Fensters (13, 13a-b) in der oberen dritten Maskenschicht (9) in einem maskenlosen Prozessschritt;
Umstrukturieren der mittleren zweiten Maskenschicht (7) unter Verwendung des zweiten Fensters (13, 13a-b) in der oberen dritten Maskenschicht (9) zum Übertragen des zweiten Fensters (13, 13a-b) in die mittlere zweite Maskenschicht (7);
Strukturieren des Halbleitersubstrats (1) unter Verwendung der strukturierten unteren dritten Maskenschicht (5);
Umstrukturieren der unteren ersten Maskenschicht (5) unter Verwendung des zweiten Fensters (13, 13a-b) in der mittleren zweite Maskenschicht (7); und
Umstrukturieren des Halbleitersubstrats (1) unter Verwendung der umstrukturierten unteren dritten Maskenschicht (5).

2. Verfahren nach Anspruch 1,
**dadurch gekennzeichnet,**
**dass** das Strukturieren der unteren ersten Maskenschicht (5) unter Verwendung des ersten Fensters (11, 11a-h) in der mittleren zweiten Maskenschicht (7) zum Übertragen des ersten Fensters (11, 11a-h) in die untere erste Maskenschicht (5) und das Vergrößern des ersten Fensters (11, 11a-h) in der oberen dritten Maskenschicht (9) simultan in einem einzigen Ätzschritt erfolgen, der selektiv zum Halbleitersubstrat (1) und zur mittleren zweiten Maskenschicht (7) ist.

3. Verfahren nach Anspruch 1 oder 2,
**dadurch gekennzeichnet,**
**dass** das Strukturieren des Halbleitersubstrats (1) unter Verwendung der strukturierten unteren dritten Maskenschicht (5) und das Umstrukturieren der mittleren zweiten Maskenschicht (7) unter Verwendung des zweiten Fensters (13, 13a-b) in der oberen dritten Maskenschicht (9) zum Übertragen des zweiten Fensters (13, 13a-b) in die mittlere zweite Maskenschicht (7) simultan in einem einzigen Ätzschritt erfolgen, der selektiv zur unteren ersten Maskenschicht (5) und zur mittleren zweiten Maskenschicht (7) ist.

4. Verfahren nach einem der vorhergehenden Ansprüche,
**dadurch gekennzeichnet,**
**dass** beim Strukturieren des Halbleitersubstrats (1) ein erster Graben (15) geschaffen wird und beim Umstrukturieren des Halbleitersubstrats (1) ein zweiter breiterer, weniger tiefer Graben (17) geschaffen wird.

5. Verfahren nach einem der vorhergehenden Ansprüche,
**dadurch gekennzeichnet,**
**dass** das Halbleitersubstrat (1) aus Siliziumoxid, die untere erste Maskenschicht (5) aus Kohlenstoff, die mittlere zweite Maskenschicht (7) aus Siliziumoxinitrid und die obere dritte Maskenschicht (9) aus Photolack bestehen.

6. Verfahren nach einem der Ansprüche 1 bis 4,
**dadurch gekennzeichnet,**
**dass** das Halbleitersubstrat (1) aus Siliziumoxid, die untere erste Maskenschicht (5) aus Polysilizium, die mittlere zweite Maskenschicht (7) aus Siliziumoxid und die obere dritte Maskenschicht (9) aus Photolack bestehen.

7. Verfahren nach einem der Ansprüche 1 bis 4,
**dadurch gekennzeichnet,**
**dass** das Halbleitersubstrat (1) aus Siliziumoxid, die untere erste Maskenschicht (5) aus Polysilizium, die mittlere zweite Maskenschicht (7) aus Siliziumnitrid und die obere dritte Maskenschicht (9) aus Photolack bestehen.

8. Verfahren nach einem der Ansprüche 1 bis 4,
**dadurch gekennzeichnet,**
**dass** das Halbleitersubstrat (1) aus Siliziumoxid, die untere erste Maskenschicht (5) aus Siliziumnitrid, die mittlere zweite Maskenschicht (7) aus Polysilizium und die obere dritte Maskenschicht (9) aus Photolack bestehen.

9. Verfahren nach einem der Ansprüche 1 bis 4,
**dadurch gekennzeichnet,**
**dass** das Halbleitersubstrat (1) aus Silizium, die untere erste Maskenschicht (5) aus Siliziumnitrid, die mittlere zweite Maskenschicht (7) aus Siliziumoxid und die obere dritte Maskenschicht (9) aus Photolack bestehen.

10. Verfahren nach einem der vorhergehenden Ansprüche,
**dadurch gekennzeichnet,**
**dass** eine Mehrzahl von ersten Fenstern (11a-h) in der oberen dritten Maskenschicht (9) gebildet wird.

11. Verfahren nach Anspruch 10,
**dadurch gekennzeichnet,**
**dass** die Mehrzahl von ersten Fenstern (11a-h) zu einer entsprechenden Mehrzahl von zweiten Fenstern in dem maskenlosen Prozessschritt vergrößert wird.

12. Verfahren nach Anspruch 10,
**dadurch gekennzeichnet,**
**dass** die Mehrzahl von ersten Fenstern (11a-h) zu einer verringerten Anzahl von zweiten Fenstern (13a-b) in dem maskenlosen Prozessschritt vergrößert wird, indem mindestens einige der ersten Fenster (11a-h) beim Vergrößern miteinander verbunden werden.

13. Verfahren nach Anspruch 12,
**dadurch gekennzeichnet,**
**dass** die ersten Fenster (11a-h) in einer oder mehreren Reihen angeordnet sind und die jeweils in einer gemeinsamen Reihe liegenden Fenster (11a-d; 11e-h) zu einem jeweiligen Streifen (13a-b) miteinander verbunden werden.

14. Verfahren nach einem der vorhergehenden Ansprüche,
**dadurch gekennzeichnet,**
**dass** das Halbleitersubstrat (1) ein Zwischenmetalldielektrikum ist.

## Claims

1. Method for production of a semiconductor structure, comprising the steps of:
making available a semiconductor substrate (1);
providing a lower, first mask layer (5), a middle, second mask layer (7) and an upper, third mask layer (9) on a surface of the semiconductor substrate (1);
forming at least one first window (11, 11a-h) in the upper, third mask layer (9);
patterning the middle, second mask layer (7) using the first window (11, 11a-h) in the upper, third mask layer (9) in order to transfer the first window (11, 11a-h) into the middle, second mask layer (7);
patterning the lower, first mask layer (5) using the first window (11, 11a-h) in the middle, second mask layer (7) in order to transfer the first window (11, 11a-h) into the lower, first mask layer (5);
increasing the size of the first window (11, 11a-h) in the upper, third mask layer (9) in order to form a second window (13, 13a-b) in the upper, third mask layer (9) in a maskless process step;
repatterning the middle, second mask layer (7) using the second window (13, 13a-b) in the upper, third mask layer (9) in order to transfer the second window (13, 13a-b) into the middle, second mask layer (7);
patterning the semiconductor substrate (1) using the patterned lower, third mask layer (5);
repatterning the lower, first mask layer (5) using the second window (13, 13a-b) in the middle, second mask layer (7); and
repatterning the semiconductor substrate (1) using the repatterned lower, third mask layer (5).

2. Method according to Claim 1, **characterized in that** the patterning of the lower, first mask layer (5) using the first window (11, 11a-h) in the middle, second mask layer (7) in order to transfer the first window (11, 11a-h) into the lower, first mask layer (5) and the increasing of the size of the first window (11, 11a-h) in the upper, third mask layer (9) are carried out simultaneously in a single etching step which is selective with respect to the semiconductor substrate (1) and with respect to the middle, second mask layer (7).

3. Method according to Claim 1 or 2, **characterized in that** the patterning of the semiconductor substrate (1) using the patterned lower, third mask layer (5) and the repatterning of the middle, second mask layer (7) using the second window (13, 13a-b) in the upper, third mask layer (9) in order to transfer the second window (13, 13a-b) into the middle, second mask layer (7) are carried out simultaneously in a single etching step which is selective with respect to the lower, first mask layer (5) and with respect to the middle, second mask layer (7).

4. Method according to one of the preceding claims, **characterized in that** during the patterning of the semiconductor substrate (1) a first trench (15) is created, and during the repatterning of the semiconductor substrate (1) a second, wider and shallower trench (17) is created.

5. Method according to one of the preceding claims, **characterized in that** the semiconductor substrate (1) consists of silicon oxide, the lower, first mask layer (5) consists of carbon, the middle, second mask layer (7) consists of silicon oxynitride, and the upper, third mask layer (9) consists of photoresist.

6. Method according to one of Claims 1 to 4, **characterized in that** the semiconductor substrate (1) consists of silicon oxide, the lower, first mask layer (5) consists of polysilicon, the middle, second mask layer (7) consists of silicon oxide and the upper, third mask layer (9) consists of photoresist.

7. Method according to one of Claims 1 to 4, **characterized in that** the semiconductor substrate (1) consists of silicon oxide, the lower, first mask layer (5) consists of polysilicon, the middle, second mask layer (7) consists of silicon nitride and the upper, third mask layer (9) consists of photoresist.

8. Method according to one of Claims 1 to 4, **characterized in that** the semiconductor substrate (1) consists of silicon oxide, the lower, first mask layer (5) consists of silicon nitride, the middle, second mask layer (7) consists of polysilicon and the upper, third mask layer (9) consists of photoresist.

9. Method according to one of Claims 1 to 4, **characterized in that** the semiconductor substrate (1) consists of silicon, the lower, first mask layer (5) consists of silicon nitride, the middle, second mask layer (7) consists of silicon oxide and the upper, third mask layer (9) consists of photoresist.

10. Method according to one of the preceding claims, **characterized in that** a plurality of first windows (11a-h) is formed in the upper, third mask layer (9).

11. Method according to Claim 10, **characterized in that** the plurality of first windows (11a-h) is increased in size to form a corresponding plurality of second windows in the maskless process step.

12. Method according to Claim 10, **characterized in that** the plurality of first windows (11a-h) is increased in size to form a reduced number of second windows (13a-b) in the maskless process step as a result of at least some of the first windows (11a-h) being joined together when their size is increased.

13. Method according to Claim 12, **characterized in that** the first windows (11a-h) are arranged in one or more rows, and the windows (11a-d; 11e-h) in each case belonging to the same row are joined together to form in each case a strip (13a-b).

14. Method according to one of the preceding claims, **characterized in that** the semiconductor substrate (1) is an intermetal dielectric.

## Revendications

1. Procédé de fabrication pour une structure à semi-conducteurs comprenant les étapes suivantes :
- préparer un substrat semi-conducteur (1) ;
- prévoir une première couche de masquage inférieure, une deuxième couche de masquage médiane et une troisième couche de masquage supérieure (5, 7, 9) sur une surface du substrat semi-conducteur (1) ;
- former au moins une première fenêtre (11, 11a-h) dans la troisième couche de masquage supérieure (9) ;
- structurer la deuxième couche de masquage médiane (7) en utilisant la première fenêtre (11, 11ah) dans la troisième couche de masquage supérieure (9) pour le transfert de la première fenêtre (11, 11a-h) dans la deuxième couche de masquage médiane (7) ;
- structurer la première couche de masquage inférieure (5) en utilisant la première fenêtre (11, 11a-h) dans la deuxième couche de masquage médiane (7) pour le transfert de la première fenêtre (11, 11a-h) dans la première couche de masquage inférieure (5) ;
- agrandir la première fenêtre (11, 11a-h) dans la troisième couche de masquage supérieure (9) pour former une deuxième fenêtre (13, 13a-b) dans la troisième couche de masquage supérieure (9) dans une étape de processus sans masque ;
- restructurer la deuxième couche de masquage médiane (7) en utilisant la deuxième fenêtre (13, 13a-b) dans la troisième couche de masquage supérieure (9) pour le transfert de la deuxième fenêtre (13, 13a-b) dans la deuxième couche de masquage médiane (7) ;
- structurer le substrat semi-conducteur (1) en utilisant la troisième couche de masquage inférieure structurée (5) ;
- restructurer la première couche de masquage inférieure (5) en utilisant la deuxième fenêtre (13, 13a-b) dans la deuxième couche de masquage médiane (7) ; et
- restructurer le substrat semi-conducteur (1) en utilisant la troisième couche de masquage inférieure restructurée (5).

2. Procédé selon la revendication 1, **caractérisé en ce que** la structuration de la première couche de masquage inférieure (5) en utilisant la première fenêtre (11, 11a-h) dans la deuxième couche de masquage médiane (7) pour le transfert de la première fenêtre (11, 11a-h) dans la première couche de masquage inférieure (5) et l'agrandissement de la première fenêtre (11, 11a-h) dans la troisième couche de masquage supérieure (9) s'effectuent simultanément en une seule étape de gravure qui est sélective par rapport au substrat semi-conducteur (1) et par rapport à la deuxième couche de masquage médiane (7).

3. Procédé selon la revendication 1 ou 2, **caractérisé en ce que** la structuration du substrat semi-conducteur (1) en utilisant la troisième couche de masquage inférieure structurée (5) et la restructuration de la deuxième couche de masquage médiane (7) en utilisant la deuxième fenêtre (13, 13a-b) dans la troisième couche de masquage supérieure (9) pour le transfert de la deuxième fenêtre (13, 13a-b) dans la deuxième couche de masquage médiane (7) s'effectuent simultanément en une seule étape de gravure qui est sélective par rapport à la première couche de masquage inférieure (5) et par rapport à la deuxième couche de masquage médiane (7).

4. Procédé selon l'une des revendications précédentes, **caractérisé en ce que**, lors de la structuration du substrat semi-conducteur (1), une première tranchée (15) est créée et, lors de la restructuration du substrat semi-conducteur (1), une deuxième tranchée (17) plus large et moins profonde est créée.

5. Procédé selon l'une des revendications précédentes, **caractérisé en ce que** le substrat semi-conducteur (1) est en oxyde de silicium, la première couche de masquage inférieure (5) en carbone, la deuxième couche de masquage médiane (7) en oxynitrure de silicium et la troisième couche de masquage supérieure (9) en laque photosensible.

6. Procédé selon l'une des revendications 1 à 4, **caractérisé en ce que** le substrat semi-conducteur (1) est en oxyde de silicium, la première couche de masquage inférieure (5) en polysilicium, la deuxième couche de masquage médiane (7) en oxyde de silicium et la troisième couche de masquage supérieure (9) en laque photosensible.

7. Procédé selon l'une des revendications 1 à 4, **caractérisé en ce que** le substrat semi-conducteur (1) est en oxyde de silicium, la première couche de masquage inférieure (5) en polysilicium, la deuxième couche de masquage médiane (7) en nitrure de silicium et la troisième couche de masquage supérieure (9) en laque photosensible.

8. Procédé selon l'une des revendications 1 à 4, **caractérisé en ce que** le substrat semi-conducteur (1) est en oxyde de silicium, la première couche de masquage inférieure (5) en nitrure de silicium, la deuxième couche de masquage médiane (7) en polysilicium et la troisième couche de masquage supérieure (9) en laque photosensible.

9. Procédé selon l'une des revendications 1 à 4, **caractérisé en ce que** le substrat semi-conducteur (1) est en silicium, la première couche de masquage inférieure (5) en nitrure de silicium, la deuxième couche de masquage médiane (7) en oxyde de silicium et la troisième couche de masquage supérieure (9) en laque photosensible.

10. Procédé selon l'une des revendications précédentes, **caractérisé en ce que** plusieurs premières fenêtres (11a-h) sont formées dans la troisième couche de masquage supérieure (9).

11. Procédé selon la revendication 10, **caractérisé en ce que** les premières fenêtres (11a-h) sont agrandies en un nombre correspondant de deuxièmes fenêtres dans l'étape de processus sans masque.

12. Procédé selon la revendication 10, **caractérisé en ce que** les premières fenêtres (11a-h) sont agrandies en un nombre réduit de deuxièmes fenêtres (13a-b) dans l'étape de processus sans masque du fait qu'au moins quelques-unes des premières fenêtres sont réunies les unes aux autres lors de l'agrandissement.

13. Procédé selon la revendication 12, **caractérisé en ce que** les premières fenêtres (11a-h) sont agencées sur une ou plusieurs rangées et **en ce que** les fenêtres (11a-d ; 11e-h) se trouvant respectivement dans une rangée commune sont réunies les unes aux autres en une bande respective (13a-b).

14. Procédé selon l'une des revendications précédentes, **caractérisé en ce que** le substrat semi-conducteur (1) est un diélectrique intermétallique.
